Europäisches Patentamt

European Patent Office

Office européen des brevets

(19)

(11) **EP 0 592 260 B1**

(12) **FASCICULE DE BREVET EUROPEEN**

(45) Date de publication et mention
de la délivrance du brevet:
**19.11.1997 Bulletin 1997/47**

(51) Int Cl.⁶: **H03K 23/50**, H03K 23/00,
H03K 23/58, H03K 23/66

(21) Numéro de dépôt: **93402155.1**

(22) Date de dépôt: **03.09.1993**

(54) **Circuit de comptage pour division de fréquence, et synthétiseur équipé d'un tel circuit**

Zählschaltung für Frequenzteilung und Synthetisierer mit einer derartigen Schaltung

Counting circuit for frequency division and synthetizer using such a circuit

(84) Etats contractants désignés:
**DE FR IT**

(30) Priorité: **11.09.1992 FR 9210842**

(43) Date de publication de la demande:
**13.04.1994 Bulletin 1994/15**

(73) Titulaire: **THOMSON-CSF**
**75008 Paris (FR)**

(72) Inventeur: **Boutigny, Pierre-Henri**
**F-92402 Courbevoie Cedex (FR)**

(74) Mandataire: **Courtellemont, Alain et al**
**THOMSON-CSF-S.C.P.I.,**
**13, Avenue du Président**
**Salvador Allende**
**94117 Arcueil Cédex (FR)**

(56) Documents cités:
**WO-A-89/10028**

• **PATENT ABSTRACTS OF JAPAN vol. 9, no. 61**
**(E-303)19 Mars 1985 & JP-A-59 201 529**

# Description

La présente invention se rapporte aux circuits de comptage et en particulier aux circuits de comptage conçus pour effectuer une division par un nombre entier p supérieur à 1, c'est-à-dire pour recevoir, par exemple, des impulsions et fournir une impulsion pour p impulsions reçues.

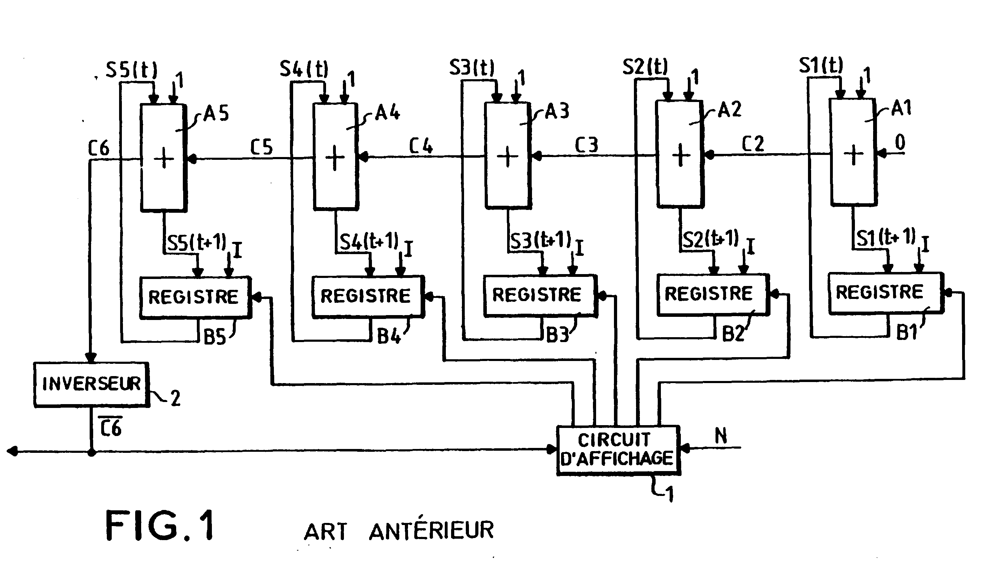

Les circuits de comptage sont connus qui comportent une chaîne d'additionneurs binaires et des registres de rebouclage associés à chacun des additionneurs ; un de ces circuits connus sera décrit plus loin à l'aide de la figure 1.

Ces circuits de comptage sont employés en particulier dans des boucles de phase de synthétiseurs de fréquence, or, pour réduire le bruit et pour pouvoir travailler avec des pas de synthèse très petits, il faut compter à une fréquence aussi élevée que possible. Avec les circuits de comptage connus la fréquence maximale de comptage est limitée par le temps de comptage d'une impulsion, c'est-à-dire que la période minimale des impulsions à compter doit au moins être égale à la somme des temps de comptage des additionneurs binaires de la chaîne.

La présente invention a pour objet de réduire cette période minimale.

Ceci est obtenue en différant la transmission des retenues entre les additionneurs de la chaîne ; cette façon de procéder ne va plus permettre d'avoir le compte du circuit de comptage par lecture de l'état des registres de rebouclage mais le circuit de comptage continuera à fonctionner en diviseur de fréquence en fournissant une impulsion relativement à p impulsions reçues.

Selon l'invention il est proposé un circuit de comptage pour recevoir un signal d'entrée présentant une caractéristique répétitive et fournir un signal de sortie pour une suite de p des caractéristiques du signal d'entrée, où p est un entier supérieur à 1, ce circuit comportant k, ou k est un entier supérieur à 1, additionneurs binaires associés dans un montage en série, ce montage ayant une sortie pour délivrer le signal de sortie, k registres de rebouclage dont le changement d'état est autorisé à chaque caractéristique répétitive du signal d'entrée, pour reboucler chaque additionneur sur lui-même et un circuit d'affichage pour commander l'état des registres de rebouclage en fonction du signal de sortie, caractérisé en ce qu'il comporte k registres tampons dont le changement d'état est autorisé à chaque caractéristique répétitive du signal d'entrée, insérés dans le montage en série où ils constituent k circuits de sortie de retenue pour, respectivement, les k additionneurs.

La présente invention sera mieux comprise et d'autres caractéristiques apparaîtront à l'aide de la description ci-après et des figures s'y rapportant qui représentent:

- la figure 1, un circuit de comptage selon l'art connu,
- la figure 2, un circuit de comptage selon l'invention,
- les figures 3 et 4, des tableaux relatifs à l'évolution dans le temps des signaux en différents endroits du circuit selon la figure 2.

La figure 1 représente un circuit de comptage selon l'art connu, comportant cinq additionneurs A1 à A5, connectés dans un montage en série. Chaque additionneur comporte une première, une deuxième et une troisième entrée, une sortie d'addition et une sortie de retenue ; les sorties de retenue des additionneurs A1 à A5 fournissent des signaux de retenue respectivement notés C2 à C6 ; les sorties de retenue des additionneurs A1 à A4 sont respectivement réunies aux premières entrées des additionneurs A2 à A5 pour réaliser le montage en série. Les cinq additionneurs A1 à A5 sont respectivement associés à cinq registres de rebouclage, B1 à B5, formés chacun à partir d'une bascule dont le changement d'état est autorisé par les impulsions d'un signal d'entrée, I, du circuit de comptage ; le rôle du circuit de comptage est principalement d'effectuer une division sur le nombre d'impulsions contenues dans son signal d'entrée I. Chacun des registres comporte une entrée de commande de basculement et une sortie reliées respectivement à la sortie d'addition et à la troisième entrée de l'additionneur auquel le registre considéré est associé ; les registres B1 à B5 comportent également une entrée de commande de l'état de leur bascule, et ces cinq entrées de commande sont respectivement reliées aux cinq sorties d'un circuit d'affichage, 1, constitué par un registre à cinq positions dont l'état est commandé par un signal binaire N correspondant à la division à effectuer. Le circuit d'affichage comporte une entrée de commande d'affichage dans les registres B1 à B5 et cette entrée reçoit le signal C6 de la sortie de retenue de l'additionneur A5 à travers un inverseur 2 ; c'est ce même signal inversé, $\overline{C6}$, fourni par l'inverseur 2 qui constitue le signal de sortie du circuit de comptage.

Le circuit de comptage selon la figure 1 est utilisé en décompteur de N à O avec N entier supérieur à 1 et inférieur à 32 ; pour ce mode de fonctionnement une tension représentant le niveau 0 logique est appliquée sur la première entrée de l'additionneur A1 et une tension représentant le niveau 1 logique est appliquée sur la deuxième entrée des additionneurs A1 à A5.

Le circuit de comptage selon la figure 1 fonctionne par décomptage d'une unité à chaque impulsion de son signal d'entrée I ; ce décomptage commence à partir de la valeur N affichée dans les registres B1 à B5 à l'aide du circuit 1 ; le compte du circuit de comptage est donné, à tout moment, par le contenu des registres B1 à B5

$$S(t) = [S5(t), S4(t), S3(t), S2(t), S1(t)]$$

et

$$S(t+1) = S(t) - 1$$

avec t + 1 = temps de l'impulsion du signal I qui suit l'impulsion apparue au temps t, avec S(t) = N au moment de l'affichage par le circuit 1 de la valeur N dans les registres B1 à B5, et avec S(t) = 0 après N impulsions du signal I. Cette arrivée au compte S(t) = 0 est marquée par le changement d'état de la sortie d'addition de l'additionneur A5 qui était jusqu'alors restée dans son état initial du moment de l'affichage et qui ne se maintient dans ce nouvel état que pendant la durée d'une impulsion ; ce changement d'état déclenche à l'impulsion suivante un nouvel affichage de la valeur N dans les registres B1 à B5 et un nouveau cycle de comptage de N+1 impulsions.

Avec le circuit de comptage selon la figure 1 la période minimale du signal I, c'est-à-dire le temps minimal pour traiter une impulsion du signal d'entrée I, est égale à la somme des temps de calcul des cinq additionneurs en série et d'un registre de rebouclage, puisque les registres B1 à B5 sont déclenchés simultanément par le signal I. Et, en conséquence, avec par exemple, un signal I fait d'impulsions à une fréquence de 200 MHz correspondant à une période de 5 nS et un temps de 1 nS nécessaire au fonctionnement d'un registre de rebouclage, le temps maximal de calcul de chacun des cinq additionneurs A1 à A5 est de

$$(5 \text{ nS} - 1\text{nS})/5 = 800 \text{ PS}$$

Dans ce qui suit va être décrit un nouveau circuit de comptage capable de fonctionner avec une période minimale du signal I beaucoup plus faible que dans le cas du circuit de la figure 1, et cela sans améliorer les caractéristiques des registres et des additionneurs employés ; et, si ce n'est pas une plus grande rapidité de fonctionnement qui est recherchée mais un coût inférieur, le circuit de comptage, bien qu'employant plus de composants, pourra voir son prix fortement réduit par l'utilisation d'additionneurs beaucoup moins rapides.

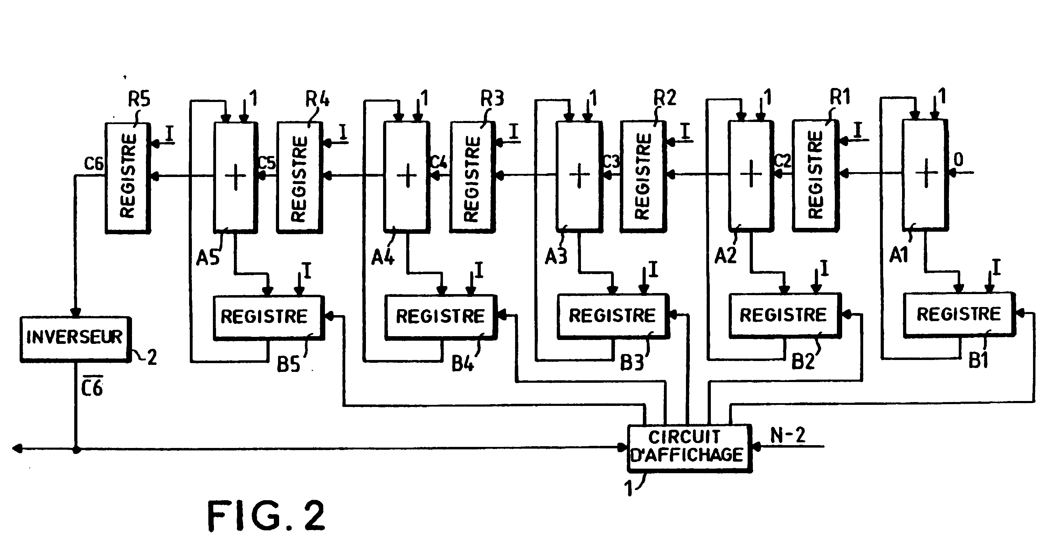

Ce nouveau circuit de comptage est représenté sur la figure 2 ; il se distingue du circuit de comptage selon la figure 1 par cinq registres tampons, R1 à R5, adjoints respectivement aux cinq sorties de retenue des additionneurs A1 à A5. Ces registres tampons sont formés chacun à partir d'une bascule dont le changement d'état est autorisé par les impulsions du signal d'entrée I.

Le rôle des registres tampons R1 à R5 est de mettre en mémoire d'une impulsion à la suivante les signaux de retenue élaborés par les additionneurs ; toute retenue élaborée lors d'une impulsion du signal I est donc conservée en mémoire pour être traitée lors de l'impulsion suivante il en résulte deux caractéristiques de ce nouveau circuit :

- la période minimale du signal I est égale à la somme de temps de calcul d'un seul additionneur et d'un registre de rebouclage ; il y a donc intérêt à choisir cette somme pour qu'elle soit sensiblement égale à la période minimale du signal I tout en lui étant inférieure,

- le compte du circuit de comptage n'est plus donné par l'état des registres de rebouclage seuls mais par l'état des registres de rebouclage et des registres tampons.

Le fait que le compte du circuit de comptage ne soit plus donné par l'état des seuls registres B1 à B5 n'empêche pas le fonctionnement en diviseur de fréquence de ce circuit de comptage. La seule chose dont il faut tenir compte c'est de ce que, lors du basculement du registre tampon R6 marquant la fin d'un cycle de comptage, c'est-à-dire une impulsion du signal I après le changement d'état de l'additionneur A5, des retenues sont encore en mémoire dans les registres tampons. Le basculement du registre tampon R6 correspond à $\overline{C6} = 1$. Dans ce qui suit S5, S4, S3, S2, S1 désignent les états des registres B5 à B1 et C5, C4, C3, C2 désignent comme dans le cas de la figure 2 les retenues provenant des additionneurs A4 à A1 mais considérées après les sorties des registres de sortie de ces additionneurs. Dans ces conditions, le compte du circuit de comptage est donné par

$$S + C = (S5, S4, S3, S3, S1) + (C5, C4, C3, C2)$$

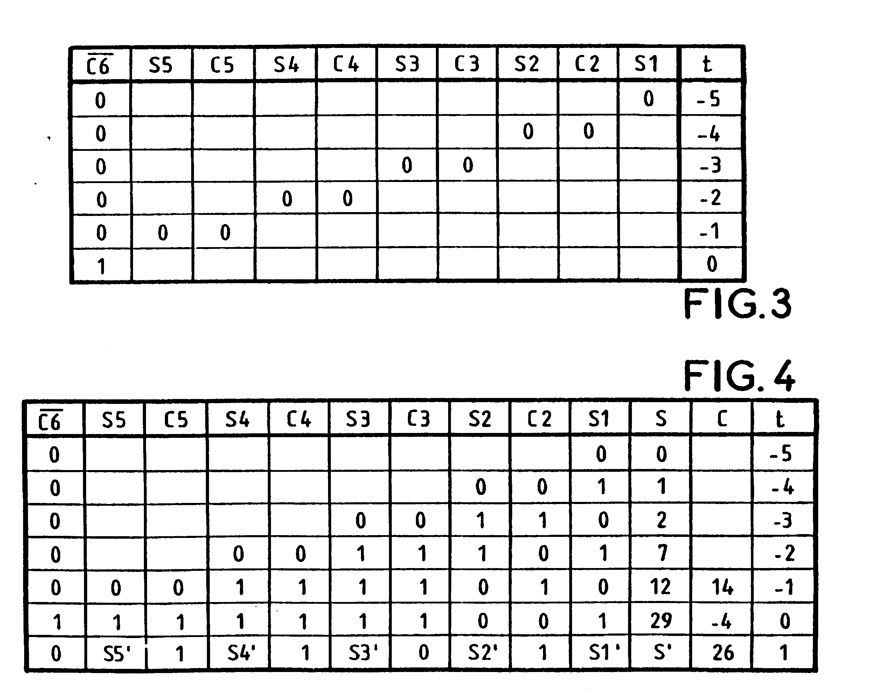

où lorsque $\overline{C6}$ est égal à 1 la retenue C est négative et est donnée par le complément à 32 de (C5, C4, C3, C2) précédé du signe moins. Avec ces conventions d'écriture il est facile, dans le tableau selon la figure 3, partant de l'état final t = 0 et $\overline{C6} = 0$, de calculer la diagonale du tableau pour les instants qui précèdent l'instant t = 0 de respectivement 1, 2, 3, 4 et 5 périodes du signal I. Il est ensuite facile de remplir les cases sous la diagonale sachant que Sn et C(n + 1) au temps t+1 sont respectivement le bit de poids faible et le bit de poids fort de

$$Sn(t) + Cn(t)+1$$

compte-tenu de la valeur S' = (S5', S4', S3', S2', S1') qui est chargée au temps t = 1 c'est-à-dire une période du signal I après le passage à 1 de $\overline{C6}$ il est également possible de remplir les lignes correspondant aux temps t = 1, 2, 3.... Le tableau selon la figure 4 a été rempli de la manière indiquée ci-avant mais sans dépasser le temps t = 1 et en indiquant alors par S1', S2', S3', S4', S5' les valeurs respectives du bit chargé dans les registres B1 à B5.

Il est à noter que, dans le cas d'un circuit de comptage sur cinq bits comme celui représenté en figure 2, du fait des retenues la valeur du compte en début de cycle, c'est-à-dire à t = 1, est S' + 26 ; cette valeur est de 29-4 = 25 en fin de cycle c'est-à-dire à t = 0, si bien que le cycle a une durée de

$$(S' + 26) - 25 + 1 = S' + 2$$

il faut donc non pas afficher la valeur N dans les registres B1 à B5 mais la valeur N - 2 afin d'obtenir une division par N. De la même manière, avec un circuit de comptage sur un nombre de bits supérieur à 1 et différent de cinq il faudra tenir compte des retenues gardées en mémoire dans les registres R1 à R5 pour non pas afficher N mais N - K où K est une valeur fonction du nombre de bits du circuit de comptage.

La présente invention n'est pas limitée à l'exemple décrit, elle n'est même pas limitée à un circuit de comptage sur un nombre de bits différent de cinq. En effet l'invention s'applique également à un circuit de comptage fonctionnant en compteur et non pas en décompteur comme dans l'exemple décrit. Et il est à noter que le circuit de comptage selon l'invention ne nécessite pas un signal d'entrée périodique. De plus le circuit de comptage selon l'invention peut être réalisé pour effectuer un comptage sur n'importe quel signal d'entrée présentant une caractéristique répétitive propre à commander les registres utilisés dans ce circuit de comptage ; si nécessaire il sera précédé d'un circuit d'adaptation conçu pour transformer un premier signal présentant une caractéristique répétitive non utilisable par les registres en un second signal présentant une caractéristique répétitive utilisable.

## Revendications

1. Circuit de comptage pour recevoir un signal d'entrée (I) présentant une caractéristique répétitive et fournir un signal de sortie pour une suite de p des caractéristiques du signal d'entrée, où p est un entier supérieur à 1, ce circuit comportant k, ou k est un entier supérieur à 1, additionneurs binaires (A1-A5) associés dans un montage en série (1, A1-A5) ce montage ayant une sortie pour délivrer le signal de sortie, k registres de rebouclage (B1-B5) dont le changement d'état est autorisé à chaque caractéristique répétitive du signal d'entrée (I), pour reboucler chaque additionneur sur lui-même et un circuit d'affichage (1) pour commander l'état des registres de rebouclage en fonction du signal de sortie, caractérisé en ce qu'il comporte k registres tampons (R1-R5) dont le changement d'état est autorisé à chaque caractéristique répétitive du signal d'entrée (I), insérés dans le montage en série où ils constituent k circuits de sortie de retenue pour, respectivement, les k additionneurs.

2. Circuit de comptage selon la revendication 1, dont la caractéristique répétitive du signal d'entrée qu'il reçoit présente une période donnée, caractérisé en ce que les additionneurs (A1-A5) et les registres de rebouclage (B1-B5) sont choisis avec des temps de travail tels que la somme des temps de travail d'un additionneur et d'un registre de rebouclage soit sensiblement égale à la période donnée tout en lui étant inférieure.

3. Synthétiseur de fréquence, caractérisé en ce qu'il est équipé d'un circuit de comptage selon l'une des revendications précédentes.

## Patentansprüche

1. Zählschaltung, die ein ein sich wiederholendes Merkmal aufweisendes Eingangssignal (I) empfängt und ein Ausgangssignal nach einer Folge von p dieser Eingangssignal-Merkmale liefert, wobei p eine ganze Zahl größer als 1 ist, mit k Binäraddierern (A1 bis A5) in einer Serienanordnung (1, Al bis A5), die an einem Ausgang das Ausgangssignal liefert, wobei k eine ganze Zahl größer als 1 ist, mit k Rückkopplungsregistern (B1 bis B5), deren Zustandswechsel bei jedem Auftreten des sich wiederholendes Merkmals des Eingangssignals (I) autorisiert wird, wobei jeder Addierer über eines der Rückkopplungsregister auf sich selbst zurückgeschleift ist, und mit einer Anzeigeschaltung (1), die den Zustand der Rückkopplungsregister abhängig vom Ausgangssignal steuert, dadurch gekennzeichnet, daß die Schaltung k Pufferregister (R1 bis R5) aufweist, deren Zustandswechsel bei jedem Auftreten des sich wiederholenden Merkmals des Eingangssignals (I) autorisiert wird und die in die Serienanordnung eingefügt sind, wo sie k Übertrags-Ausgangsschaltungen für je einen der k Addierer bilden.

2. Zählschaltung nach Anspruch 1, in der das sich wiederholende Merkmal des empfangenen Eingangssignals eine bestimmte Periode besitzt, dadurch gekennzeichnet, daß die Addierer (A1 bis A5) und die Rückkopplungsregister (B1 bis B5) mit solchen Arbeitsgeschwindigkeiten gewählt sind, daß die Summe der Schaltzeiten eines Addierers und eines Rückkopplungsregisters im wesentlichen der bestimmten Periode gleicht, aber geringer als diese ist.

3. Frequenzsynthetisierer, dadurch gekennzeichnet, daß er eine Zählschaltung nach einem der vorhergehenden Ansprüche besitzt.

## Claims

1. Counting circuit for receiving an input signal (I) exhibiting a repetitive characteristic and for providing an output signal for a string of p of the characteristics of the input signal, where p is an integer greater than 1, this circuit including k, where k is an integer greater than 1, binary adders (A1-A5) associated in a series arrangement (1, A1-A5), this arrangement having an output for delivering the output signal, k wraparound registers (B1-B5) whose change of state is enabled with each repetitive characteristic of the input signal (1), for wrapping each adder around on itself and a display circuit (1) for controlling the state of the wraparound registers as a function of the output signal, characterized in that it includes k buffer registers (R1-R5) whose change of state is enabled with each repetitive characteristic of the input signal (1), and which are inserted into the series arrangement where they constitute k carry output circuits for, respectively, the k adders.

2. Counting circuit according to Claim 1, for which the repetitive characteristic of the input signal which it receives exhibits a given period, characterized in that the adders (A1-A5) and the wraparound registers (B1-B5) are chosen with operating times such that the sum of the operating times of an adder and of a wraparound register are substantially equal to the given period while being less than it.

3. Frequency synthesizer, characterized in that it is equipped with a counting circuit according to one of the preceding claims.

FIG. 1   ART ANTÉRIEUR

EP 0 592 260 B1

FIG.2

7

## FIG.3

| $\overline{C6}$ | S5 | C5 | S4 | C4 | S3 | C3 | S2 | C2 | S1 | t |
|---|---|---|---|---|---|---|---|---|---|---|
| 0 | | | | | | | | | 0 | -5 |
| 0 | | | | | | | 0 | 0 | | -4 |
| 0 | | | | | 0 | 0 | | | | -3 |
| 0 | | | 0 | 0 | | | | | | -2 |
| 0 | 0 | 0 | | | | | | | | -1 |
| 1 | | | | | | | | | | 0 |

## FIG.4

| $\overline{C6}$ | S5 | C5 | S4 | C4 | S3 | C3 | S2 | C2 | S1 | S | C | t |
|---|---|---|---|---|---|---|---|---|---|---|---|---|
| 0 | | | | | | | | | 0 | 0 | | -5 |
| 0 | | | | | | | 0 | 0 | 1 | 1 | | -4 |
| 0 | | | | | 0 | 0 | 1 | 1 | 0 | 2 | | -3 |
| 0 | | | 0 | 0 | 1 | 1 | 1 | 0 | 1 | 7 | | -2 |
| 0 | 0 | 0 | 1 | 1 | 1 | 1 | 0 | 1 | 0 | 12 | 14 | -1 |
| 1 | 1 | 1 | 1 | 1 | 1 | 1 | 0 | 0 | 1 | 29 | -4 | 0 |
| 0 | S5' | 1 | S4' | 1 | S3' | 0 | S2' | 1 | S1' | S' | 26 | 1 |